# EUROPÄISCHE PATENTSCHRIFT

(11) **EP 3 861 362 B1**
(45) Veröffentlichungstag und Bekanntmachung des Hinweises auf die Patenterteilung: **16.08.2023**
(21) Anmeldenummer: 19778918.3
(22) Anmeldetag: 23.09.2019
(51) Int. Cl.: H01M 10/42, G01R 31/36, H01M 10/48

(54) **ANZEIGEVORRICHTUNG FÜR EINEN AKKUPACK**
INDICATING DEVICE FOR A BATTERY PACK
DISPOSITIF D'AFFICHAGE POUR UN BLOC-BATTERIE

(30) Priorität: 02.10.2018 DE 102018216937
(43) Veröffentlichungstag der Anmeldung: 11.08.2021
(73) Patentinhaber: Robert Bosch GmbH, 70442 Stuttgart (DE)
(72) Erfinder: KLEE, Christoph, 70599 Stuttgart (DE); SEGRET, Mickael, 70569 Stuttgart (DE)
(86) Internationale Anmeldenummer: PCT/EP2019/075496
(87) Internationale Veröffentlichungsnummer: WO 2020/069892

(56) Entgegenhaltungen:
- EP-A1- 1 906 711
- WO-A1-2018/145324
- US-A- 3 796 951
- US-A- 4 743 897
- US-A1- 2004 046 673
- US-A1- 2006 197 722
- US-A1- 2015 022 335
- Peter Cheung: "Lecture 7, Digital-to-analogue conversion", , 13. November 2011 (2011-11-13), Seiten 1-16, XP055645894, Imperial College London Gefunden im Internet: URL:http://citeseerx.ist.psu.edu/viewdoc/d ownload?rep=rep1&type=pdf&doi=10.1.1.224.1 596 [gefunden am 2019-11-25]

## Beschreibung

### Stand der Technik

Es ist bereits eine Anzeigevorrichtung für einen Akkupack, insbesondere einen Akkupack eines Elektrowerkzeugs, zum Anzeigen eines Ladezustands des Ackupacks, mit zumindest einer Ladezustandsanzeigeeinheit, die zumindest ein Anzeigeelement zum Anzeigen des Ladezustands des Akkupacks aufweist und mit zumindest einer Steuerleitung zu einer Übertragung von zumindest einem, insbesondere von einem Ladezustand des Akkupacks abhängigen, elektrischen und/oder elektronischen Signal von einer zur Ladezustandsanzeigeeinheit, insbesondere baulich getrennten, separaten Kontrolleinheit des Akkupacks, insbesondere von einer Hauptsteuerelektronik des Akkupacks, zur Ladezustandsanzeigeeinheit, vorgeschlagen worden.

So offenbart US 2015/022335 eine Statusanzeige für den Zustand einer betriebsrelevanten Komponente eines Kraftfahrzeugs, die unter anderem den aktuellen Ladezustand der Batterie anzeigt.

Weitere Beispiele für Anzeigevorrichtungen in elektronischen Geräten sind in WO 2018/145324 A1, US 3 796 951 A, US 2006/197722 A1, EP 1 906 711 A1 oder US 4 743 897 A zu sehen.

### Offenbarung der Erfindung

Die Erfindung wird durch die beigefügten Ansprüche definiert.

Die Erfindung geht aus von einer Anzeigevorrichtung für einen Akkupack, insbesondere einen Akkupack eines Elektrowerkzeugs, zum Anzeigen eines Ladezustands des Akkupacks, mit zumindest einer Ladezustandsanzeigeeinheit, die zumindest ein Anzeigeelement zum Anzeigen des Ladezustands des Akkupacks aufweist und mit zumindest einer Steuerleitung zu einer Übertragung von zumindest einem, insbesondere von einem Ladezustand des Akkupacks abhängigen, elektrischen und/oder elektronischen Signal von einer zur Ladezustandsanzeigeeinheit, insbesondere baulich getrennten, separaten Kontrolleinheit des Akkupacks, insbesondere von einer Hauptsteuerelektronik des Akkupacks, zur Ladezustandsanzeigeeinheit.

Es wird vorgeschlagen, dass die Ladezustandsanzeigeeinheit dazu eingerichtet ist, zumindest das eine Anzeigeelement in Abhängigkeit von dem über die Steuerleitung übertragenen elektrischen und/oder elektronischen Signal kurzzuschlie-ßen. Bevorzugt umfasst die Anzeigevorrichtung zum Anzeigen eines Ladezustands des Akkupacks, zumindest eine Ladezustandsanzeigeeinheit, die zumindest ein Anzeigeelement zum Anzeigen des Ladezustands des Akkupacks aufweist, und zumindest eine Steuerleitung zu einer Übertragung von zumindest einem elektrischen und/oder elektronischen Signal von einer zur Ladezustandsanzeigeeinheit separaten Kontrolleinheit des Akkupacks zur Ladezustandsanzeigeeinheit.

Vorteilhafterweise ist die Anzeigevorrichtung dazu eingerichtet, insbesondere zumindest in Abhängigkeit von einer Packspannung des Akkupacks, einen Ladezustand des Akkupacks über das zumindest eine Anzeigeelement auszugeben. Vorzugsweise wird einem Benutzer über ein Verhältnis von einer Anzahl von kurzgeschlossenen Anzeigeelementen zu einer Gesamtanzahl von Anzeigeelementen ein anteiliger Ladezustand des Akkupacks angezeigt. Vorteilhafterweise ist die Anzeigevorrichtung zumindest teilweise an einer Außenwand eines Gehäuses des Akkupacks angeordnet. Vorzugsweise ist die Anzeigevorrichtung derart im und/oder am Gehäuse des Akkupacks angeordnet, dass zumindest das Anzeigeelement, insbesondere in einem im akkubetriebenen Gerät angeordneten Zustand des Akkupacks, für einen Benutzer erreichbar und/oder einsehbar ist. Insbesondere ist die Anzeigevorrichtung räumlich getrennt oder beabstandet von einer restlichen Elektronik, insbesondere der Kontrolleinheit des Akkupacks und/oder der Hauptsteuerelektronik des Akkupacks, ausgebildet. Vorzugsweise verbindet zumindest die Steuerleitung die Anzeigevorrichtung, insbesondere leitend, mit der restlichen Elektronik, insbesondere der Kontrolleinheit des Akkupacks und/oder der Hauptsteuerelektronik des Akkupacks. Vorteilhafterweise ist die Kontrolleinheit des Akkupacks dazu eingerichtet, die Anzeigevorrichtung mittels des elektrischen und/oder elektronischen Signals zu steuern.

Bevorzugt ist das elektrische und/oder elektronische Signal als Spannungs- und/oder Strompegel ausgebildet. Vorteilhafterweise wird das elektrische und/oder elektronische Signal von der Kontrolleinheit des Akkupacks, insbesondere der Hauptsteuerelektronik des Akkupacks, in Abhängigkeit von einem Ladezustand des Akkupacks generiert. Unter "eingerichtet" soll insbesondere speziell programmiert, ausgelegt und/oder ausgestattet verstanden werden. Darunter, dass ein Objekt zu einer bestimmten Funktion eingerichtet ist, soll insbesondere verstanden werden, dass das Objekt diese bestimmte Funktion in zumindest einem Anwendungs- und/oder Betriebszustand erfüllt und/oder ausführt. Unter "kurzschließen" soll insbesondere ein Überbrücken eines elektrischen Elements mittels einer Verbindung von zwei elektrischen Leitungen eines Stromkreises verstanden werden, wobei zumindest ein Großteil eines Stromes über die elektrischen Leitungen fließt und ein Strom durch das elektrische Element, insbesondere durch einen hohen elektrischen Widerstand des elektrischen Elements im Vergleich zu den elektrischen Leitungen, zumindest im Wesentlichen vernachlässigbar ist. Unter "zumindest im Wesentlichen vernachlässigbar" soll in diesem Zusammenhang insbesondere verstanden werden, dass ein Wert derart gering, besonders bevorzugt nahe null ist, dass eine Messung und/oder Funktion des Wertes innerhalb einer Vorrichtung, keine sichtbare und/oder anders erkennbare Wirkung und/oder Reaktion hervorruft. Vorzugsweise ist der Strom der über das Anzeigeelement fließt durch das Kurzschließen des Anzeigeelements so gering, das das Anzeigeelement nicht aktiviert wird.

Vorteilhafterweise weist die Ladezustandsanzeigeeinheit zumindest mehr als ein Anzeigeelement auf. Bevorzugt weist die Ladezustandsanzeigeeinheit genau drei Anzeigeelemente auf. Es ist jedoch auch denkbar, dass die Ladezustandsanzeigeeinheit eine von genau drei abweichende Anzahl an Anzeigeelementen aufweist, wie beispielsweise genau vier, genau fünf oder mehr Anzeigeelemente. Vorteilhafterweise ist das zumindest eine Anzeigeelement als Leuchtdiode (LED) und/oder LED-Leuchtelement, insbesondere LED-Leuchtstreifen, ausgebildet. Es sind jedoch auch andere einem Fachmann bekannte Ausgestaltungen des Anzeigeelements denkbar. Insbesondere weist die Ladezustandsanzeigeeinheit zumindest einen Widerstand, zumindest ein Anzeigeelement und zumindest ein Schaltelement zum Kurzschließen des Anzeigeelements in Abhängigkeit von dem über die Steuerleitung übertragenen elektrischen und/oder elektronischen Signal auf.

Vorteilhafterweise weist die Anzeigevorrichtung genau drei Leitungen auf, welche die Anzeigevorrichtung, insbesondere die Ladezustandsanzeigeeinheit der Anzeigevorrichtung, zumindest mit der restlichen Elektronik des Akkupacks verbindet. Es ist jedoch auch denkbar, dass die Anzeigevorrichtung, insbesondere die Ladezustandsanzeigeeinheit, eine von drei abweichende Anzahl an Leitungen aufweist, um die Anzeigevorrichtung, insbesondere die Ladezustandsanzeigeeinheit, mit der restlichen Elektronik des Akkupacks zu verbinden. Vorteilhafterweise weist die Anzeigevorrichtung genau eine Steuerleitung, genau eine Versorgungsleitung und genau eine Masseleitung auf. Insbesondere verbindet die Versorgungsleitung die Anzeigevorrichtung, insbesondere die Ladezustandsanzeigeeinheit der Anzeigevorrichtung, zumindest mit einer Energiespeichereinheit des Akkupacks, insbesondere um eine Packspannung zur Verfügung zu stellen, welche zumindest abhängig vom Ladezustand des Akkupacks ist. Bevorzugt verbindet die Masseleitung die Anzeigevorrichtung, insbesondere die Ladezustandsanzeigeeinheit der Anzeigevorrichtung, zumindest mit einer Masse als Null-Potential, insbesondere einem Erder und/oder einem Schutzleitnetz des Ackupacks oder eines mit dem Akkupack verbundenen Elektrowerkzeugs.

Durch die erfindungsgemäße Ausgestaltung der Anzeigevorrichtung kann eine vorteilhaft einfache, kompakte und gleichzeitig flexibel positionierbare Anzeigevorrichtung mit vorteilhaft geringen Kosten ermöglicht werden, insbesondere da teure Bauteile, wie beispielsweise elektrische Verbindungen zum Ansteuern einzelner Anzeigeelemente oder Bauteile zum separaten Messen einer Packspannung des Akkupacks, eingespart werden können.

Des Weiteren wird vorgeschlagen, dass die Ladezustandsanzeigeeinheit zumindest ein Transistorelement aufweist, welches parallel geschaltet zum Anzeigeelement angeordnet ist und dazu eingerichtet ist, in Abhängigkeit von einem über die Steuerleitung übertragenen elektrischen und/oder elektronischen Signal, zumindest das Anzeigeelement kurzzuschließen. Vorzugsweise ist das Transistorelement als zumindest ein Transistor, zumindest ein Bipolartransistor oder zumindest ein Feldeffekttransistor ausgebildet. Vorteilhafterweise wird das Transistorelement vom elektrischen und/oder elektronischen Signal über die Steuerleitung geschaltet. Bevorzugt wird durch eine Schaltung des Transistorelements zumindest das Anzeigeelement kurzgeschlossen. Vorteilhafterweise ist das Transistorelement so angeordnet, dass eine Leitermasche, bis auf das Anzeigeelement und das Transistorelement bauteilfrei ausgebildet ist. Es ist jedoch denkbar, dass die Leitermasche zwischen dem Anzeigeelement und dem Transistorelement zumindest einen Widerstand aufweist. Unter einer "Leitermasche" soll insbesondere eine geschlossene Leitung aus beliebigen elektrischen Bauteilen verstanden werden, wobei die Leitermasche über beliebig viele Knotenpunkte mit anderen leitenden Bauteilen verbunden sein kann. Bevorzugt weist die Ladezustandsanzeigeeinheit, im Fall dass mehrere Anzeigeelemente vorgesehen sind, zumindest für jedes Anzeigeelement ein Transistorelement auf. Durch die erfindungsgemäße Ausgestaltung kann eine vorteilhaft einfache und kompakte Anzeigevorrichtung erreicht werden, da insbesondere ein Messen der Packspannung des Akkupacks entfallen kann und alle Anzeigeelemente über ein Signal gesteuert werden können.

Zudem wird vorgeschlagen, dass die Anzeigevorrichtung zumindest zwei mit der Steuerleitung elektrisch leitend verbundene Steuerwiderstände aufweist, die jeweils, insbesondere direkt, mit zumindest einem Signalausgang der Kontrolleinheit des Akkupacks verbunden sind. Insbesondere soll ein "Steuerwiderstand" als zweipoliges passives elektrisches Bauelement zur Realisierung eines ohmschen Widerstandes in einer elektrischen und/oder elektronischen Schaltung verstanden werden, welcher, insbesondere in der Steuerleitung, ein Signal zur Steuerung eines elektrischen Bauteils, insbesondere der Ladezustandsanzeigeeinheit, zumindest signifikant verändert. Unter "zumindest signifikant verändert" soll insbesondere verstanden werden, dass ein Parameter und/oder ein Wert eines Signals und/oder einer Messung um zumindest 20 %, vorzugsweise 30 % und besonders bevorzugt 40 % seiner ursprünglichen Größe geändert wird/werden. Vorzugsweise sind die Steuerwiderstände dazu eingerichtet, aus zumindest zwei Spannungspegeln der Signalausgänge der Kontrolleinheit des Akkupacks, insbesondere der Hauptsteuerelektronik des Akkupacks, zumindest mehr als ein unterschiedliches elektrisches und/oder elektronisches Signal zur Steuerung der Ladezustandsanzeigeeinheit zu generieren. Bevorzugt wird aus jeweils einem Signalausgang der Kontrolleinheit des Akkupacks genau ein Spannungspegel, insbesondere in Abhängigkeit von einem Ladezustand des Akkupacks, ausgegeben. Vorteilhafterweise sind die Steuerwiderstände dazu eingerichtet, aus den genau zwei jeweiligen Spannungspegeln der Kontrolleinheit des Akkupacks genau vier verschiedene elektrische und/oder elektronische Signale, insbesondere genau vier verschiedene Spannungspegel, zur Steuerung der Ladezustandsanzeigeeinheit zu generieren. Es ist jedoch auch denkbar, dass die Steuerwiderstände aus einer von genau zwei Spannungspegeln verschiedenen Anzahl an Spannungspegeln der Kontrolleinheit eine von genau vier Spannungspegeln verschiedene Anzahl an Spannungspegeln zur Steuerung der Ladezustandsanzeigeeinheit generiert. Durch die erfindungsgemäße Ausgestaltung kann eine vorteilhaft hohe Schnelligkeit und Zuverlässigkeit der Anzeigevorrichtung ermöglicht werden, da ein gewünschtes Spannungsniveau zur Steuerung der Ladezustandsanzeigeeinheit schneller erzeugt werden kann wie beispielsweise mittels einem Auf- und Entladen eines Kondensators. Außerdem kann durch die erfindungsgemäße Ausgestaltung eine vorteilhaft geringe Prozessorlast der Kontrolleinheit des Akkupacks erreicht werden.

Ferner wird vorgeschlagen, dass die Anzeigevorrichtung zumindest eine Bedieneinheit aufweist, die zumindest ein Bedienelement aufweist, welches dazu eingerichtet ist, die Ladezustandsanzeigeeinheit über die Kontrolleinheit des Akkupacks, insbesondere die Hauptsteuerelektronik des Akkupacks, zu aktivieren. Vorteilhafterweise ist die Bedieneinheit zumindest mit der Versorgungsleitung und der Steuerleitung verbunden. Vorzugsweise ist das Bedienelement zwischen der Versorgungsleitung und der Masseleitung angeordnet. Vorzugsweise ist das Bedienelement als Schalter, Taster und/oder Hebel ausgebildet. Es sind aber auch andere, einem Fachmann sinnvoll erscheinende Ausgestaltungen des Bedienelements denkbar. Vorteilhafterweise umfasst die Bedieneinheit, insbesondere zusätzlich zum Bedienelement, zumindest einen Transistor und zumindest einen Widerstand. Zusätzlich oder alternativ ist denkbar, dass die Bedieneinheit, insbesondere zusätzlich zum Bedienelement, zumindest eine Diode aufweist, welche insbesondere dazu eingerichtet ist, einen Spannungsabfall an dem Widerstand der Bedieneinheit zu begrenzen, insbesondere um eine Verringerung der Packspannung des Akkupacks zu reduzieren und/oder eine abfallende thermische Leistung zu reduzieren. Vorzugsweise weist die Bedieneinheit zwei seriell geschaltete Dioden auf. Vorzugsweise wird bei einer Betätigung des Bedienelements der Transistor der Bedieneinheit geschaltet, wodurch zumindest ein Spannungspegel an der Kontrolleinheit des Akkupacks verändert wird, wobei insbesondere zumindest ein Spannungspegel an dem Signalausgang der Kontrolleinheit des Akkupacks ausgegeben wird, insbesondere um die Ladezustandsanzeigeeinheit über die Steuerleitung zu aktivieren. Durch die erfindungsgemäße Ausgestaltung kann eine vorteilhaft zuverlässige und fehlerfreie Anzeigevorrichtung mit einer vorteilhaft hohen Bedienfreundlichkeit und einem vorteilhaft niedrigen Stromverbrauch ermöglicht werden, insbesondere da durch die Bedieneinheit ein gesamtheitlicher Spannungsabfall an Widerständen während eines Betriebs verringert werden kann. Durch die alternative Ausgestaltung mit den seriell geschalteten Dioden kann zusätzlich eine störende Verlustleistung innerhalb der Anzeigevorrichtung verringert werden. Außerdem kann durch die erfindungsgemäße Ausgestaltung sichergestellt werden, dass die Packspannung für zumindest im Wesentlichen alle Ladezustände des Akkupacks zur Versorgung der Anzeigeelemente ausreicht.

Des Weiteren wird vorgeschlagen, dass die Ladezustandsanzeigeeinheit zumindest eine Spannungsstabilisierungseinheit umfasst, welche zumindest eine Zehnerdiode aufweist. Vorzugsweise ist die Spannungsstabilisierungseinheit zumindest zwischen der Versorgungsleitung und der restlichen Ladezustandsanzeigeeinheit ausgebildet. Vorzugsweise ist die Spannungsstabilisierungseinheit dazu eingerichtet, eine abfallende thermische Leistung der Ladezustandsanzeigeeinheit zu reduzieren. Bevorzugt ist die Spannungsstabilisierungseinheit dazu eingerichtet, einen Stromfluss in einem Ruhezustand der Ladezustandsanzeigeeinheit zu verhindern. Vorteilhafterweise ist die Zehnerdiode in Sperrrichtung zur Versorgungsleitung angeordnet. Es ist jedoch auch denkbar, dass die Spannungsstabilisierungseinheit zusätzlich zur Zehnerdiode einen Transistor und einen parallel zur Zehnerdiode geschalteten Widerstand aufweist, wobei insbesondere der Transistor über den Widerstand und die Zehnerdiode geschaltet wird und bei einem Schalten eine Packspannung des Akkupacks an der restlichen Ladezustandsanzeigeeinheit anliegt. Durch die erfindungsgemäße Ausgestaltung kann eine Anzeigevorrichtung mit einem vorteilhaft geringen Stromverbrauch ermöglicht werden, insbesondere da durch die Zehnerdiode eine Spannung auf der Versorgungsleitung begrenzt werden kann. Außerdem kann durch die erfindungsgemäße Ausgestaltung die abfallende Leistung zwischen mehreren Bauteilen, insbesondere der Zehnerdiode, dem Transistor und dem Widerstand, aufgeteilt werden.

Zudem wird vorgeschlagen, dass die Ladezustandsanzeigeeinheit zumindest einen Umverteilungswiderstand aufweist, welcher dazu eingerichtet ist, den Leistungsabfall innerhalb der Ladezustandsanzeigeeinheit zu verteilen, wobei der Umverteilungswiderstand zwischen dem Anzeigeelement und einem Transistorelement der Ladezustandsanzeigeeinheit angeordnet ist. Insbesondere soll ein "Umverteilungswiderstand" als zweipoliges passives elektrisches Bauelement zur Realisierung eines ohmschen Widerstandes in einer elektrischen und/oder elektronischen Schaltung verstanden werden, durch welchen eine an der elektrischen und/oder elektronischen Schaltung abfallende Leistung, insbesondere durch Wärme, innerhalb der elektrischen und/oder elektronischen Schaltung auf zumindest zwei Bauteile, insbesondere Widerstände, aufgeteilt wird. Vorzugsweise ist der Umverteilungswiderstand in einer Leitermasche mit dem Anzeigeelement und dem Transistorelement ausgebildet. Vorteilhafterweise weist die Ladezustandsanzeigeeinheit im Fall, dass mehrere Anzeigeelemente vorgesehen sind, zumindest für jedes Anzeigeelement einen Umverteilungswiderstand auf. Alternativ oder zusätzlich zu dem zumindest einen Umverteilungswiderstand kann zumindest ein zusätzlicher Transistor in der Ladezustandsanzeigeeinheit verwendet werden, der dazu eingerichtet ist, einen elektrischen Strom zu einer Versorgung des zumindest einen Anzeigeelements, und dadurch insbesondere auch eine in Wärme abfallende Leistung, auf mehrere Punkte innerhalb der Anzeigevorrichtung zu verteilen. Durch die erfindungsgemäße Ausgestaltung kann eine vorteilhaft sichere Anzeigevorrichtung erreicht werden, da insbesondere durch den zumindest einen Umverteilungswiderstand eine in Wärme umgesetzte Leistung auf mehrere Punkte innerhalb der Anzeigevorrichtung verteilt wird. Dadurch kann eine lokale Überhitzung innerhalb des Akkupacks vermieden werden, was häufig zu einer Schädigung des Akkupacks, eines mit dem Akkupack betriebenen Werkzeugs und/oder eines Benutzers führen kann.

Des Weiteren wird ein Akkupack, insbesondere ein Akkupack eines Elektrowerkzeugs, mit zumindest einer Kontrolleinheit, insbesondere einer Hauptsteuerelektronik, und mit zumindest einer erfindungsgemäßen Anzeigevorrichtung vorgeschlagen. Vorzugsweise ist die Kontrolleinheit des Akkupacks, insbesondere die Hauptsteuerelektronik des Akkupacks, mit der Anzeigevorrichtung, insbesondere leitend, verbunden. Vorteilhafterweise ist die Anzeigevorrichtung zumindest teilweise an einer Außenwand des Akkupacks angeordnet. Vorzugsweise ist zumindest ein Anzeigeelement der Anzeigevorrichtung an der Außenwand des Akkupacks angeordnet, insbesondere derart angeordnet, dass das Anzeigeelement in einem eingebauten Zustand des Akkupacks von einem Benutzer gut sichtbar und/oder zugänglich ist. Vorteilhafterweise umfasst der Akkupack zumindest eine Energiespeichereinheit, welche insbesondere mit der Kontrolleinheit des Akkupacks, insbesondere der Hauptsteuerelektronik des Akkupacks, und mit der Anzeigevorrichtung zumindest zeitweise, insbesondere leitend, verbunden ist. Bevorzugt stellt die Energiespeichereinheit in Abhängigkeit von einem Ladezustand zumindest eine Packspannung zur Verfügung, welche zumindest an der Anzeigevorrichtung und/oder der Kontrolleinheit des Akkupacks, insbesondere der Hauptsteuerelektronik des Akkupacks, anliegt. Vorteilhafterweise ist die Anzeigevorrichtung dazu eingerichtet, zumindest einen momentanen Ladezustand des Akkupacks über ein Kurzschließen von zumindest einem Anzeigeelement der Anzeigevorrichtung auszugeben. Vorzugsweise wird das Anzeigeelement in Abhängigkeit vom momentanen Ladezustand des Akkupacks kurzgeschlossen. Bevorzugt weist die Anzeigevorrichtung zumindest zwei, insbesondere genau 3, genau 4 oder genau 5, Anzeigeelemente auf, wobei insbesondere mit einer Abnahme des momentanen Ladezustands des Akkupacks eine steigende Anzahl von Anzeigeelementen, insbesondere in gleichen Anteilen zu einer Gesamtzahl der Anzeigeelemente wie der Anteil des momentanen Ladezustands des Akkupacks zu einer maximalen Akkukapazität, kurzgeschlossen wird. Durch die erfindungsgemäße Ausgestaltung des Akkupacks mit der Anzeigevorrichtung kann ein vorteilhaft sicherer und kompakter Akkupack mit vorteilhaft geringen Kosten erreicht werden.

Ferner geht die Erfindung aus von einem Verfahren zum Anzeigen eines Ladezustands eines Akkupacks, insbesondere eines Akkupacks eines Elektrowerkzeugs, mittels zumindest einer erfindungsgemäßen Anzeigevorrichtung. Es wird vorgeschlagen, dass in zumindest einem Verfahrensschritt zumindest ein Anzeigeelement einer Ladezustandsanzeigeeinheit in Abhängigkeit von einem, insbesondere von einem Ladezustand des Akkupacks abhängigen, über eine Steuerleitung übertragenen elektrischen und/oder elektronischen Signals einer zur Ladezustandsanzeigeeinheit, insbesondere baulich getrennten, separaten Kontrolleinheit des Akkupacks, insbesondere einer Hauptsteuerelektronik des Akkupacks, kurzgeschlossen wird.

Vorteilhafterweise erfolgt mittels des Verfahrens das Anzeigen des Ladezustands des Akkupacks, insbesondere eines anteiligen Ladezustands des Akkupacks, über ein Verhältnis von einer Anzahl von kurzgeschlossenen Anzeigeelementen zu einer Gesamtanzahl von Anzeigeelementen der Anzeigevorrichtung. Vorzugsweise erfolgt ein Kurzschließen des Anzeigeelements, wenn eine Packspannung des Akkupacks einen vordefinierten und/oder dynamisch ermittelten Grenzwert unterschreitet. Vorzugsweise ist der Grenzwert als ein prozentualer Anteil einer maximalen Kapazität des Akkupacks ausgebildet. Durch die erfindungsgemäße Ausgestaltung des Verfahrens kann eine vorteilhaft einfache Anzeige des Ladezustands mit vorteilhaft geringen Kosten ermöglicht werden. Zusätzlich kann durch die erfindungsgemäße Ausgestaltung ein vorteilhaft kostengünstiges Verfahren zur Anzeige des Ladezustands erreicht werden, insbesondere da teure Bauteile, wie beispielsweise elektrische Verbindungen zum Ansteuern einzelner Anzeigeelemente oder Bauteile zum separaten Messen einer Packspannung des Akkupacks, eingespart werden können.

Zudem wird vorgeschlagen, dass in zumindest einem Verfahrensschritt aus zumindest zwei Spannungspegeln der Kontrolleinheit des Akkupacks, insbesondere der Hauptsteuerelektronik des Akkupacks, mittels zumindest zwei Steuerwiderstände zumindest mehr als ein unterschiedliches elektrisches und/oder elektronisches Signal zur Steuerung der Ladezustandsanzeigeeinheit generiert wird. Vorteilhafterweise erfolgt eine Generierung der unterschiedlichen elektrischen und/oder elektronischen Signale zur Steuerung der Ladezustandsanzeigeeinheit aus zumindest zwei Spannungspegeln der Kontrolleinheit des Akkupacks mittels der Steuerwiderstände passiv, insbesondere sobald die Spannungspegel an Signalausgängen der Kontrolleinheit des Akkupacks angelegt werden. Durch die erfindungsgemäße Ausgestaltung kann eine vorteilhaft schnelle Anzeige des Ladezustands ermöglicht werden, da insbesondere ein Be- und Entladen eines Kondensators zur Generierung der unterschiedlichen Signale entfallen kann.

Ferner wird vorgeschlagen, dass ein Kurzschließen des Anzeigeelements über zumindest ein Transistorelement der Ladezustandsanzeigeeinheit erfolgt, welcher in Abhängigkeit von dem elektrischen und/oder elektronischen Signal der Kontrolleinheit des Akkupacks geschaltet wird. Vorzugsweise erfolgt die Schaltung des Transistorelements in Abhängigkeit vom Ladezustand des Akkupacks mittels des elektrischen und/oder elektronischen Signals. Vorteilhafterweise erfolgt in dem Falle, dass mehrere Anzeigeelemente zur Durchführung des Verfahrens verwendet werden das Kurzschließen eines Anzeigeelements jeweils mittels eines Transistorelements. Insbesondere wird jedes Transistorelement über einen unterschiedlichen Spannungspegel des elektrischen und/oder elektronischen Signals geschaltet. Vorzugsweise entspricht relativ zu einem Ausgangszustand mit einem zumindest im Wesentlichen vollgeladenen Akkupacks ein höherer Spannungspegel des elektrischen und/oder elektronischen Signals einem niedrigeren Ladezustand des Akkupacks, wodurch insbesondere bei einem niedrigeren Ladezustand des Akkupacks eine höhere Anzahl von Anzeigeelementen kurzgeschlossen wird. Durch die erfindungsgemäße Ausgestaltung kann eine vorteilhaft einfache, energiesparende und kostengünstige Anzeige des Ladezustands ermöglicht werden, da insbesondere eine separate Ansteuerung von Anzeigeelementen entfallen kann.

Des Weiteren wird vorgeschlagen, dass die Ladezustandsanzeigeeinheit mittels zumindest einer Packspannung des Akkupacks über zumindest eine Versorgungsleitung mit Strom versorgt wird. Bevorzugt wird die Packspannung mittels zumindest einem Widerstand in der Versorgungsleitung und/oder der Ladezustandsanzeigevorrichtung zu einer Versorgung des zumindest einen Anzeigeelements umgewandelt. Vorzugsweise erfolgt die Versorgung des zumindest einen Anzeigeelements über zumindest zwei seriell geschaltete Dioden und den Widerstand, wobei die Dioden dazu eingerichtet sind, mittels der Packspannung einen Transistor zu schalten um dadurch die Packspannung über den Widerstand am Anzeigeelement anzulegen. Vorteilhafterweise werden die Dioden in Durchlassrichtung betrieben. Durch die erfindungsgemäße Ausgestaltung kann eine vorteilhaft kompakte und kostengünstige Anzeige des Ladezustands erreicht werden, da insbesondere teure zusätzliche Leitungen zur Versorgung der Anzeigeelemente entfallen können.

Es zeigen:
- Fig. 1: eine schematische Darstellung eines Elektrowerkzeugs mit einem erfindungsgemäßen Akkupack mit einer erfindungsgemäßen Anzeigevorrichtung,
- Fig. 2: eine schematische Darstellung des erfindungsgemäßen Akkupacks mit der erfindungsgemäßen Anzeigevorrichtung,
- Fig. 3: eine schematische Darstellung der erfindungsgemäßen Anzeigevorrichtu ng,
- Fig. 4: eine schematische Darstellung eines Ablaufs eines erfindungsgemäßen Verfahrens unter Verwendung der erfindungsgemäßen Anzeigevorrichtung,
- Fig. 5: eine schematische Darstellung eines Schaltplans der erfindungsgemäßen Anzeigevorrichtung,
- Fig. 6: eine schematische Darstellung eines Schaltplans einer ersten alternativen erfindungsgemäßen Anzeigevorrichtung mit einem Schaltbild,
- Fig. 7: eine schematische Darstellung eines Schaltplans einer zweiten alternativen erfindungsgemäßen Anzeigevorrichtung,
- Fig. 8: eine schematische Darstellung eines Schaltplans einer dritten alternativen erfindungsgemäßen Anzeigevorrichtung,
- Fig. 9: eine schematische Darstellung eines Schaltplans einer vierten alternativen erfindungsgemäßen Anzeigevorrichtung,
- Fig. 10: eine schematische Darstellung eines Schaltplans einer fünften alternativen erfindungsgemäßen Anzeigevorrichtung und
- Fig. 11: eine schematische Darstellung eines Schaltplans einer sechsten alternativen erfindungsgemäßen Anzeigevorrichtung.

### Beschreibung der Ausführungsbeispiele

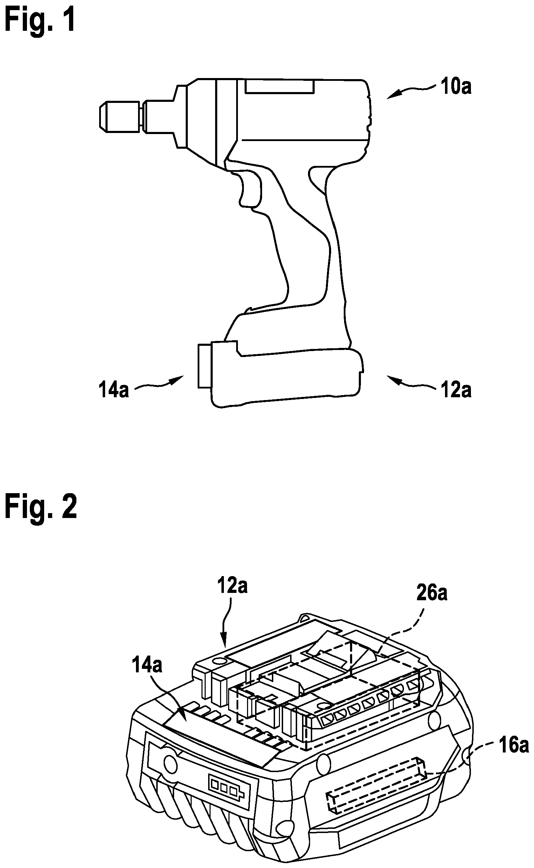

Figur 1 zeigt eine schematische Darstellung eines Elektrowerkzeugs 10a mit einem austauschbaren Akkupack 12a, wobei der Akkupack 12a eine Anzeigevorrichtung 14a zum Anzeigen eines Ladezustands des Akkupacks 12a aufweist. Das gezeigte Elektrowerkzeug 10a ist als Bohrmaschine ausgebildet. Es ist jedoch auch denkbar, dass das Elektrowerkzeug 10a als Bohrhammer, Schlaghammer, Säge, Hobel, Schrauber, Fräse, Schleifer, Winkelschleifer, Gartengerät, Baustellenmessgerät und/oder Multifunktionswerkzeug mit zumindest einem fest integrierten oder austauschbaren Akkupack 12a ausgebildet ist. Der Akkupack 12a ist dazu eingerichtet, das Elektrowerkzeug 10a mit Energie zu versorgen.

Figur 2 zeigt eine schematische Darstellung des Akkupacks 12a mit der Anzeigevorrichtung 14a zum Anzeigen eines Ladezustands des Akkupacks 12a. Der Ackupack 12a weist zumindest eine Kontrolleinheit 16a, welche insbesondere als Hauptsteuerelektronik des Akkupacks 12a ausgebildet ist, und zumindest einen Energiespeicher 26a auf. Vorteilhafterweise ist die Kontrolleinheit 16a des Akkupacks 12a dazu eingerichtet, die Anzeigevorrichtung 14a mittels zumindest eines elektrischen und/oder elektronischen Signals zu steuern. Die Kontrolleinheit 16a des Akkupacks 12a ist, insbesondere leitend, mit der Anzeigevorrichtung 14a und dem Energiespeicher 26a verbunden.

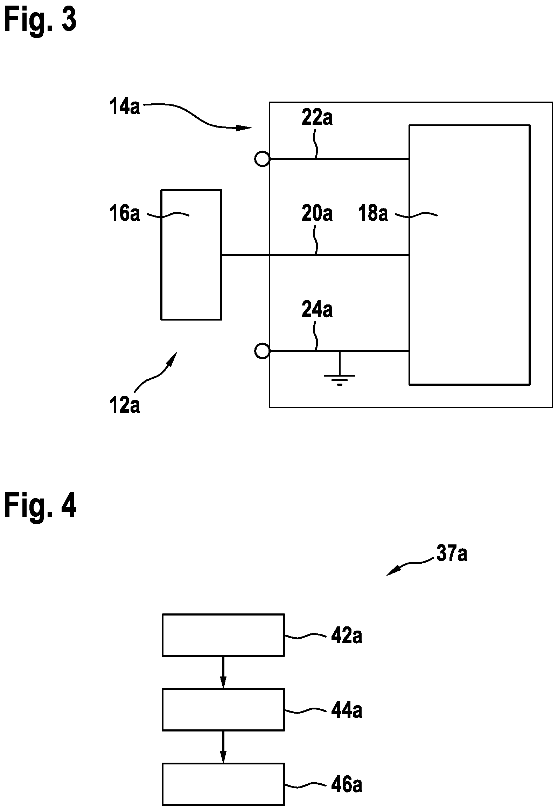

Figur 3 zeigt eine schematische Darstellung der Anzeigevorrichtung 14a des Ackupacks 12a. Die Anzeigevorrichtung 14a weist eine Ladezustandsanzeigeeinheit 18a sowie eine Steuerleitung 20a, eine Versorgungsleitung 22a und eine Masseleitung 24a auf. Die Steuerleitung 20a verbindet die Kontrolleinheit 16a des Akkupacks 12a, insbesondere leitend, mit der Ladezustandsanzeigeeinheit 18a. Die Masseleitung 24a ist dazu eingerichtet, zumindest die Ladezustandsanzeigeeinheit 18a gegen ein Null-Potential zu erden. Vorzugsweise ist die Masseleitung 24a als Erder und/oder Schutzleitnetz des Akkupacks 12a oder des mit dem Akkupack 12a verbundenen Elektrowerkzeugs 10a oder als eine andere einem Fachmann als sinnvoll erscheinende Ausgestaltung ausgebildet. Die Versorgungsleitung 22a ist dazu eingerichtet, der Anzeigevorrichtung 14a eine Packspannung des Energiespeichers 26a des Akkupacks 12a zur Verfügung zu stellen, wobei die Packspannung insbesondere einen Ladezustand des Akkupacks 12a definiert. Die Versorgungsleitung 22a ist zumindest mit der Ladezustandsanzeigeeinheit 18a, insbesondere leitend, verbunden. Besonders bevorzugt liegt an der Kontrolleinheit 16a des Akkupacks 12a auch die Packspannung an, was in Figur 3 jedoch nicht dargestellt ist.

Figur 4 zeigt eine schematische Darstellung eines Ablaufs eines Verfahrens 37a zum Anzeigen des Ladezustands des Akkupacks 12a, insbesondere unter Verwendung der Anzeigevorrichtung 14a. In zumindest einem Verfahrensschritt 42a des Verfahrens 37a wird aus zumindest zwei Spannungspegeln der Kontrolleinheit 16a des Akkupacks 12a mittels zumindest zwei Steuerwiderständen 32a zumindest mehr als ein unterschiedliches elektrisches und/oder elektronisches Signal zur Steuerung der Ladezustandsanzeigeeinheit 18a generiert. In zumindest einem Verfahrensschritt 44a des Verfahrens 37a wird zumindest ein Anzeigeelement 28a, 28a', 28a" der Ladezustandsanzeigeeinheit 18a in Abhängigkeit von einem über die Steuerleitung 20a übertragenen elektrischen und/oder elektronischen Signals der Kontrolleinheit 16a des Akkupacks 12a, insbesondere einer Hauptsteuerelektronik des Akkupacks 12a, das insbesondere abhängig ist von einem Ladezustand des Akkupacks 12a, kurzgeschlossen. In zumindest einem Verfahrensschritt 46a des Verfahrens 37a erfolgt mittels der restlichen, insbesondere nicht-kurzgeschlossenen, Anzeigeelemente 28a, 28a', 28a" eine Anzeige des Ladezustands des Akkupacks 12a.

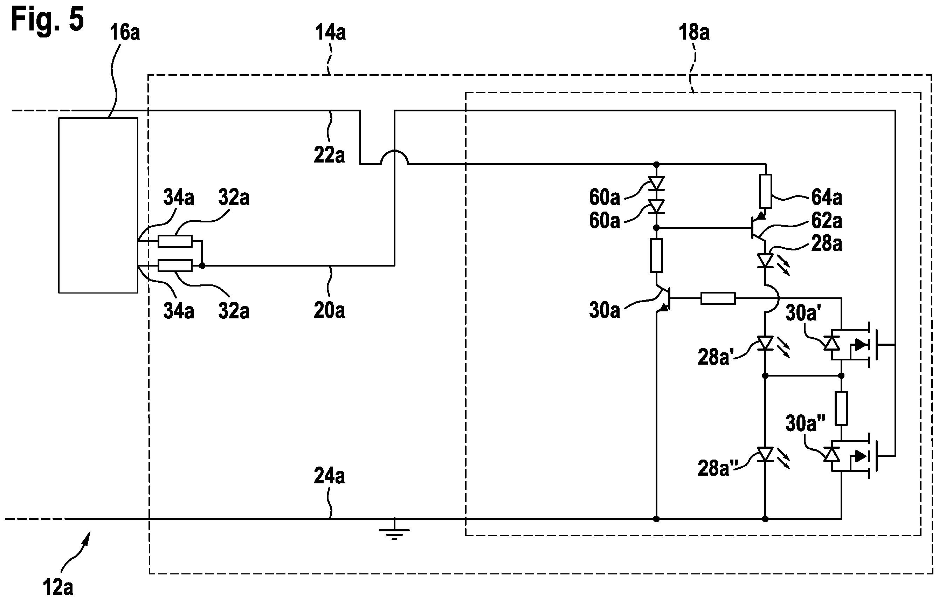

In Figur 5 ist eine schematische Darstellung eines Schaltplans der Anzeigevorrichtung 14a des Akkupacks 12a gezeigt. Die Ladezustandsanzeigeeinheit 18a weist drei Anzeigeelemente 28a, 28a', 28a" zum Anzeigen des Ladezustands auf. Vorzugsweise werden die drei Anzeigeelemente 28a, 28a', 28a" über die Kontrolleinheit 16a, insbesondere bei einem zumindest im Wesentlichen vollen Ladezustand des Akkupacks 12a, gemeinsam eingeschaltet. Insbesondere ist die Ladezustandsanzeigeeinheit 18a dazu eingerichtet, zwei der Anzeigeelemente 28a', 28a" in Abhängigkeit von dem über die Steuerleitung 20a übertragenen elektrischen und/oder elektronischen Signal kurzzuschließen. Die Anzeigeelemente 28a, 28a', 28a" sind als Leuchtdioden (LEDs) ausgebildet. Es ist jedoch auch denkbar, dass die Anzeigeelemente 28a, 28a', 28a" als eine andere, von einem Fachmann als sinnvoll erachtete Ausgestaltungausgebildet sind. Die in den Figuren 5 bis 11 gezeigten Schaltungen der Anzeigevorrichtung 14a-g sind jedoch besonders bevorzugt für als Leuchtdioden ausgebildete Anzeigeelemente 28a, 28a', 28a" eingerichtet. Die Ladezustandsanzeigeeinheit 18a weist mehrere Transistorelemente 30a, 30a', 30a", 62a auf. Die Ladezustandsanzeigeeinheit 18a weist ein erstes Transistorelement 30a, ein zweites Transistorelement 30a', ein drittes Transistorelement 30a" und ein weiteres Transistorelement 62a auf. Das erste Transistorelement 30a ist vorzugsweise dazu eingerichtet, über das weitere Transistorelement 62a den Strom für alle drei Anzeigeelemente 28a, 28a', 28a" zu regeln. Das zweite und das dritte Transistorelement 30a', 30a" der Ladezustandsanzeigeeinheit 18a, sind jeweils parallel geschaltet zu einem der Anzeigeelemente 28a', 28a" angeordnet und dazu eingerichtet, in Abhängigkeit von dem über die Steuerleitung 20a übertragenen elektrischen und/oder elektronischen Signal, insbesondere in Abhängigkeit vom Ladezustand des Akkupacks 12a, jeweils eines der Anzeigeelemente 28a', 28a" kurzzuschließen. Das zweite und dritte Transistorelement 30a', 30a", die vorzugsweise dazu eingerichtet sind, die zwei Anzeigeelemente 28a', 28a" kurzzuschließen, sind als Feldeffekttransistoren ausgebildet. Das erste und das weitere Transistorelement 30a, 62a, die dazu vorgesehen sind, den Strom für die Anzeigeelemente 28a, 28a', 28a" zu regeln, sind als komplementäre Bipolartransistoren ausgebildet. Es ist jedoch auch denkbar, dass die Transistorelemente 30a, 30a', 30a", 62a als gewöhnliche Transistoren und/oder als eine andere, einem Fachmann als sinnvoll erscheinende Ausgestaltung ausgebildet sind. Vorzugsweise werden bei einer sinkenden Packspannung des Akkupacks 12a über die Kontrolleinheit 16a nach und nach das zweite und dritte Transistorelement 30a', 30a" geschaltet und dadurch die Anzeigeelemente 28a', 28a" nach und nach kurzgeschlossen, wodurch die Anzeigeelemente 28a', 28a" zumindest im Wesentlichen stromlos ausgeschaltet werden. Bei einer weiter sinkenden Packspannung wird vorzugsweise das Transistorelement 30a stromlos geschaltet wodurch auch das letzte verbleibende Anzeigeelement 28a stromlos geschaltet wird.

Eine Stromversorgung der Anzeigeelemente 28a, 28a', 28a" erfolgt über die Versorgungsleitung 22a mittels zweier Dioden 60a, dem weiteren Transistorelement 62a und einem Widerstand 64a. Über ein Schalten des weiteren Transistorelements 62a wird insbesondere ein Stromkreis mit den Anzeigeelementen 28a, 28a', 28a" geschlossen. Liegt an der Steuerleitung 20a ein Spannungspegel an, wird die Stromversorgung der Anzeigeelemente 28a, 28a', 28a" über das erste Transistorelement 30a aktiviert. Das zweite und dritte Transistorelement 30a',30a" werden bei einem höheren Spannungspegel der Steuerleitung 20a geschaltet, insbesondere um die Anzeigeelemente 30a', 30a" in Abhängigkeit vom Ladezustand des Akkupacks 12a kurzzuschließen.

Die Steuerleitung 20a weist zwei mit der Steuerleitung 20a elektrisch leitend verbundene Steuerwiderstände 32a auf, die jeweils direkt mit einem Signalausgang 34a der Kontrolleinheit 16a des Akkupacks 12a verbunden sind. Vorzugsweise sind die Steuerwiderstände 32a dazu eingerichtet, aus zwei Spannungspegeln der Kontrolleinheit 16a des Akkupacks 12a genau vier verschiedene elektrische und/oder elektronische Signale, insbesondere genau vier verschiedene Spannungspegel, zur Steuerung der Ladezustandsanzeigeeinheit 18a zu generieren. Vorzugsweise ist die Kontrolleinheit 16a derart eingerichtet, dass sich die Spannungspegel an den Signalausgängen 34a in Abhängigkeit von der Packspannung ändern, insbesondere um die Ladezustandsanzeigeeinheit 18a zu steuern. Alternativ ist denkbar, dass die Signalgenerierung anstatt über die beiden Steuerwiderstände 32a, über einen mit einem Signalausgang 34a der Kontrolleinheit 16a verbundenen Widerstand und einen zwischen Masseleitung 24a und Steuerleitung 20a angeordneten Kondensator das elektrische und/oder elektronische Signal zum Steuern der Ladezustandsanzeigeeinheit 18a generiert wird. Vorzugsweise ist die Ladezustandsanzeigeeinheit 18a lediglich über die eine Versorgungsleitung 22a, über die eine Steuerleitung 20a und über die eine Masseleitung 24a mit der restlichen Elektronik des Akkupacks 12a verbunden.

Die in Figur 5 unbeschrifteten Widerstände der Anzeigevorrichtung 14a sind zumindest größtenteils dazu eingerichtet, das elektrische und/oder elektronische Signal der Kontrolleinheit 16a und/oder die Packspannung des Akkupacks 12a derart zu ändern, insbesondere anzupassen, dass durch die unterschiedlichen Spannungspegel die unterschiedlichen Transistorelemente 30a, 30a', 30a", 62a in Abhängigkeit von dem Ladezustand des Akkupacks 12a geschaltet werden können und/oder die Packspannung zu einer Versorgung der Anzeigeelemente 28a, 28a', 28a" angepasst werden kann.

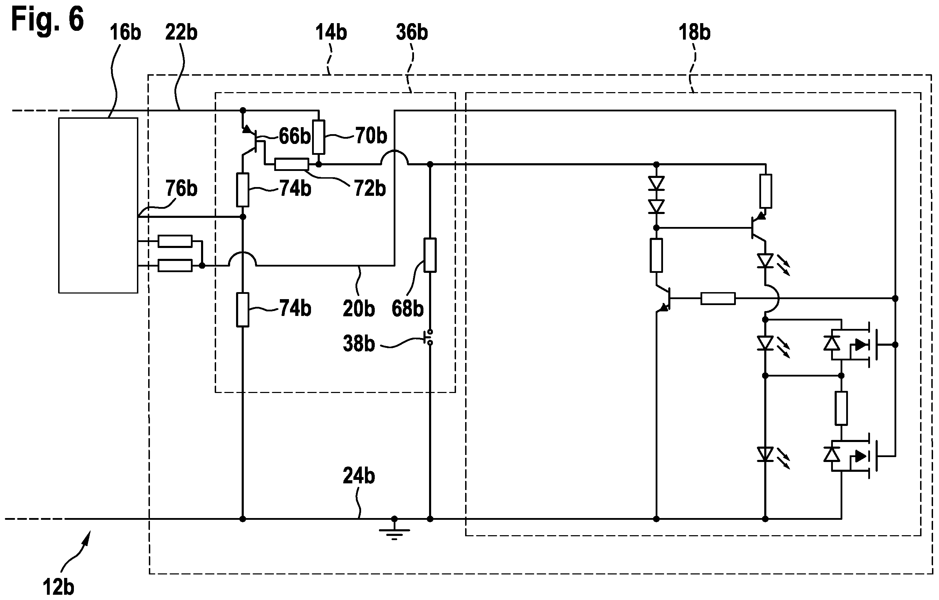

In den Figuren 6 bis 11 sind weitere Ausführungsbeispiele der Erfindung gezeigt. Die nachfolgenden Beschreibungen und die Zeichnungen beschränken sich im Wesentlichen auf die Unterschiede zwischen den Ausführungsbeispielen, wobei bezüglich gleich bezeichneter Bauteile, insbesondere in Bezug auf Bauteile mit gleichen Bezugszeichen, grundsätzlich auch auf die Zeichnungen und/oder die Beschreibung der anderen Ausführungsbeispiele, insbesondere der Figuren 1 bis 5, verwiesen werden kann. Zur Unterscheidung der Ausführungsbeispiele ist der Buchstabe a den Bezugszeichen des Ausführungsbeispiels in den Figuren 1 bis 5 nachgestellt. In den Ausführungsbeispielen der Figuren 6 bis 11 ist der Buchstabe a durch die Buchstaben b bis g ersetzt.

In Figur 6 ist eine schematische Darstellung eines Schaltplans einer ersten alternativen Anzeigevorrichtung 14b eines Akkupacks 12b gezeigt. Die Anzeigevorrichtung 14b ist zumindest größtenteils baugleich zur Anzeigevorrichtung 14a ausgebildet, jedoch umfasst die Anzeigevorrichtung 14b zusätzlich eine Bedieneinheit 36b. Die Bedieneinheit 36b weist ein Bedienelement 38b auf, welches dazu eingerichtet ist, eine Ladezustandsanzeigeeinheit 18b der Anzeigevorrichtung 14b über eine Kontrolleinheit 16b des Akkupacks 12b, insbesondere eine Hauptsteuerelektronik des Akkupacks 12b, zu aktivieren. Das Bedienelement 38b ist als Taster ausgebildet. Es ist jedoch auch denkbar, dass das Bedienelement 38b als Schalter, Hebel und/oder eine andere, einem Fachmann sinnvoll erscheinende Ausgestaltung ausgebildet ist. Weiter umfasst die Bedieneinheit 36b einen Transistor 66b und fünf zusätzliche Widerstände 68b, 70b, 72b, 74b, über die eine Versorgungsleitung 22b der Anzeigevorrichtung 14b mit der Kontrolleinheit 16b des Akkupacks 12b und einer Masseleitung 24b der Anzeigevorrichtung 14b verbunden ist. Vorteilhafterweise ist das Bedienelement 38b und der Widerstand 68b der Bedieneinheit 36b zusammen mit der Ladezustandsanzeigeeinheit 18b, insbesondere auf einer Platine der Anzeigevorrichtung 14b, angeordnet. Vorzugsweise ist die Platine mit der Ladezustandsanzeigeeinheit 18b sowie dem Bedienelement 38b und dem Widerstand 68b der Bedieneinheit 36b lediglich über die eine Versorgungsleitung 22b, über die eine Steuerleitung 20b und über die eine Masseleitung 24b mit der restlichen Elektronik des Akkupacks 12b verbunden.

Wird das Bedienelement 38b betätigt fließt über das Bedienelement 38b, die Widerstände 68b, 70b, und einen Teil der Versorgungsleitung 22b ein Strom. Dadurch wird an dem Widerstand 70b ein Spannungsabfall hervorgerufen. Durch diesen Spannungsabfall wird über den Widerstand 72b der Transistor 66b geschaltet und die Widerstände 74b der Bedieneinheit 36b wirken als Spannungsteiler, wobei ein über den Spannungsteiler fließender Strom als Signal an einem Signaleingang 76b der Kontrolleinheit 16b des Akkupacks 12b erkannt wird.

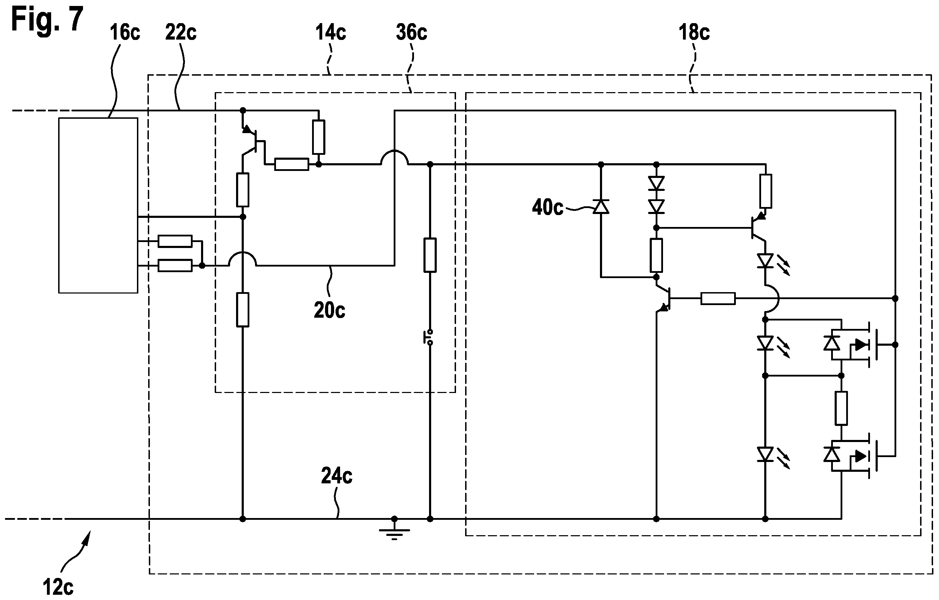

In Figur 7 ist eine schematische Darstellung eines Schaltplans einer zweiten alternativen Anzeigevorrichtung 14c eines Akkupacks 12c gezeigt. Die Anzeigevorrichtung 14c ist zumindest größtenteils baugleich zur Anzeigevorrichtung 14b ausgebildet, jedoch umfasst eine Ladezustandsanzeigeeinheit 18c der Anzeigevorrichtung 14c zusätzlich eine als Zehnerdiode ausgebildete Spannungsstabilisierungseinheit 40c. Die Spannungsstabilisierungseinheit 40c ist zwischen einer Versorgungsleitung 22c der Anzeigevorrichtung 14c und der restlichen Ladezustandsanzeigeeinheit 18c ausgebildet. Vorzugsweise ist die Spannungsstabilisierungseinheit 40c dazu eingerichtet, eine abfallende thermische Leistung der Ladezustandsanzeigeeinheit 18c zu reduzieren. Bevorzugt ist die Spannungsstabilisierungseinheit 40c dazu eingerichtet, einen Stromfluss in einem Ruhezustand der Ladezustandsanzeigeeinheit 18c zu verhindern. Vorteilhafterweise ist die als Zehnerdiode ausgebildete Spannungsstabilisierungseinheit 40c in Sperrrichtung zur Versorgungsleitung 22c angeordnet.

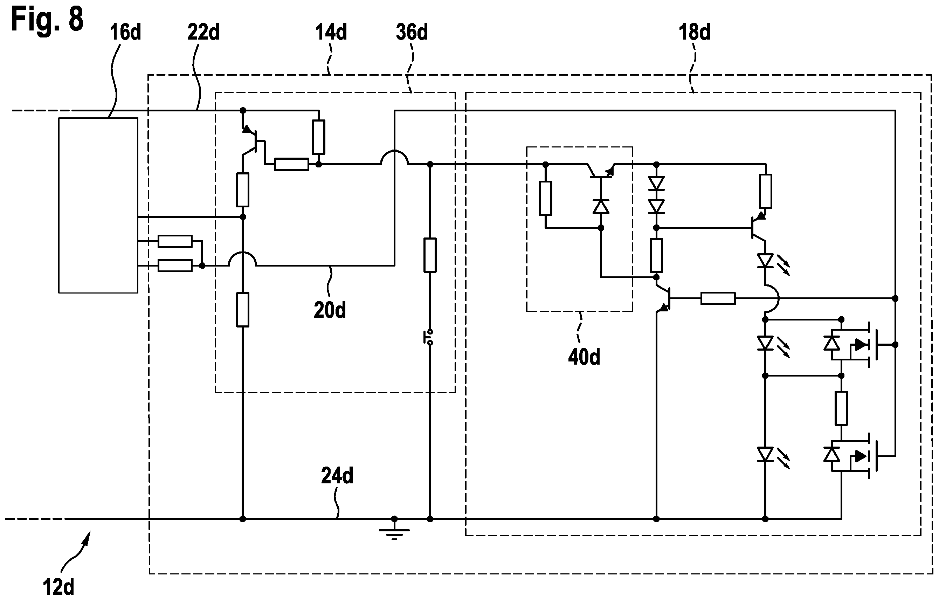

Figur 8 zeigt eine schematische Darstellung eines Schaltplans einer dritten alternativen Anzeigevorrichtung 14d eines Akkupacks 12d. Die Anzeigevorrichtung 14d ist zumindest größtenteils baugleich zur Anzeigevorrichtung 14c ausgebildet, jedoch umfasst eine Spannungsstabilisierungseinheit 40d der Anzeigevorrichtung 14d zusätzlich zu einer Zehnerdiode einen Transistor und einen parallel zur Zehnerdiode geschalteten Widerstand. Vorzugsweise wird der Transistor über den Widerstand und die Zehnerdiode geschaltet, wodurch bei einem Schalten des Transistors eine Packspannung des Akkupacks 12d an der restlichen Ladezustandsanzeigeeinheit 18d anliegt.

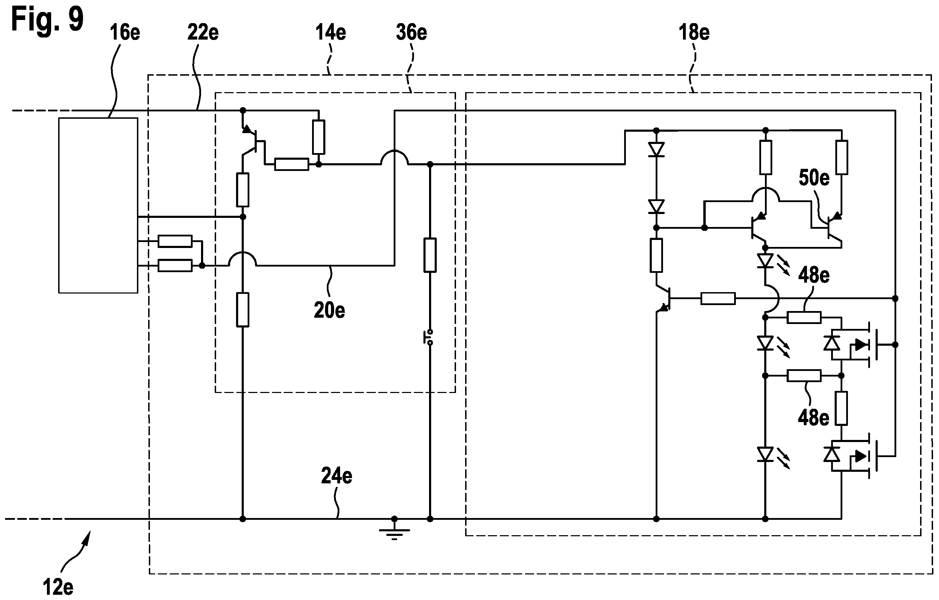

Die Figur 9 zeigt eine schematische Darstellung eines Schaltplans einer vierten alternativen Anzeigevorrichtung 14e eines Akkupacks 12e. Die Anzeigevorrichtung 14e ist zumindest größtenteils baugleich zur Anzeigevorrichtung 14b ausgebildet, jedoch umfasst eine Ladezustandsanzeigeeinheit 18e der Anzeigevorrichtung 14e zusätzlich zwei Umverteilungswiderstände 48e. Die Umverteilungswiderstände 48e sind in einer Leitermasche jeweils eines Anzeigeelements 28e der Ladezustandsanzeigeeinheit 18e angeordnet. Die Umverteilungswiderstände 48e sind dazu eingerichtet, eine als Wärme abfallende Leistung innerhalb der Anzeigevorrichtung 14e auf mehrere Punkte zu verteilen, insbesondere um eine lokale Überhitzung innerhalb des Akkupacks 12e zu vermeiden. Die Ladezustandsanzeigeeinheit 18e umfasst einen weiteren Transistor 50e, der dazu eingerichtet ist, einen elektrischen Strom zu einer Versorgung der Anzeigeelemente 28e, und dadurch insbesondere auch eine in Wärme abfallende Leistung, auf mehrere Punkte innerhalb der Anzeigevorrichtung 14e zu verteilen.

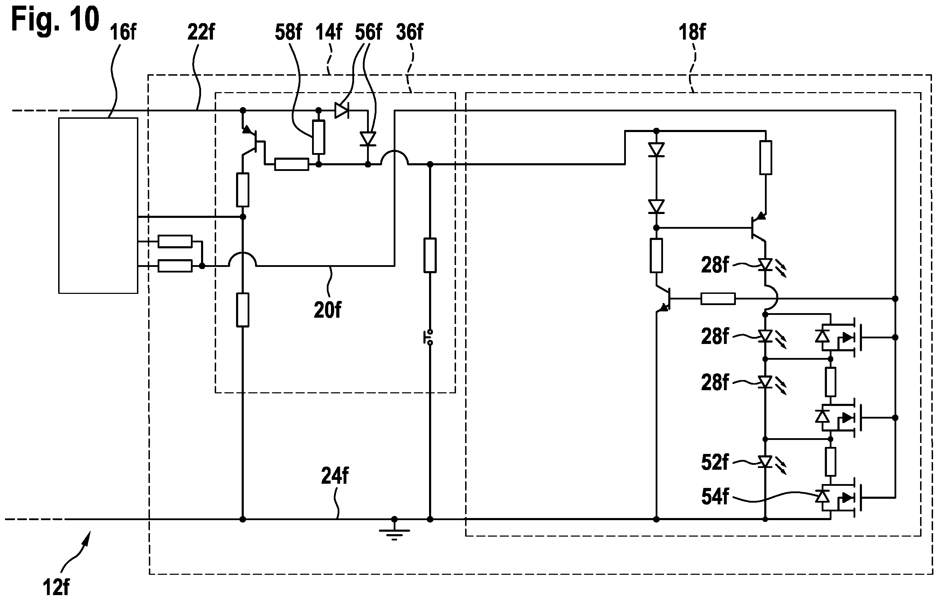

Figur 10 zeigt eine schematische Darstellung eines Schaltplans einer fünften alternativen Anzeigevorrichtung 14f eines Akkupacks 12f. Die Anzeigevorrichtung 14f ist zumindest größtenteils baugleich zur Anzeigevorrichtung 14b ausgebildet, jedoch weist eine Ladezustandsanzeigeeinheit 18f der Anzeigevorrichtung 14f insgesamt vier als Leuchtdiode ausgebildete Anzeigeelemente 28f, 52f auf. Die Ladezustandsanzeigeeinheit 18f umfasst im Vergleich zu der Anzeigevorrichtung 14b zusätzlich ein weiteres Anzeigeelement 52f und ein weiteres Transistorelement 54f, welches dazu eingerichtet ist, dass weitere Anzeigeelement 52f in Abhängigkeit von einem elektrischen und/oder elektronischen Signal einer Kontrolleinheit 16f des Akkupacks 12f kurzzuschließen. Zusätzlich umfasst eine Bedieneinheit 36f der Anzeigevorrichtung 14f zwei Dioden 56f, die dazu eingerichtet sind, einen Spannungsabfall über den zu den zwei Dioden 56f parallel geschalteten Widerstand 58f der Bedieneinheit 36f zu begrenzen.

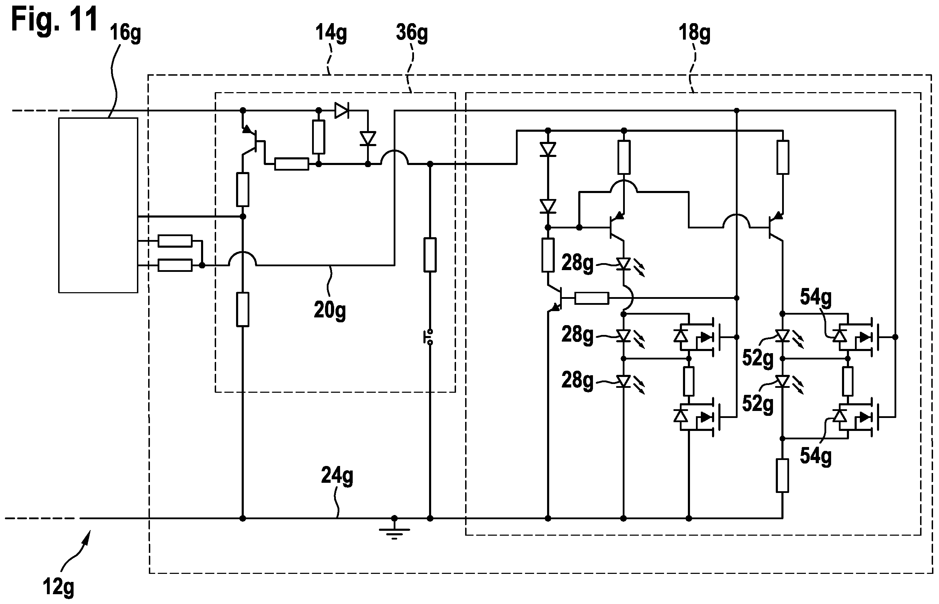

In Figur 11 ist eine schematische Darstellung eines Schaltplans einer sechsten alternativen Anzeigevorrichtung 14g eines Akkupacks 12g gezeigt. Die Anzeigevorrichtung 14g ist zumindest größtenteils baugleich zur Anzeigevorrichtung 14f ausgebildet, jedoch weist eine Ladezustandsanzeigeeinheit 18g der Anzeigevorrichtung 14g insgesamt fünf als Leuchtdiode ausgebildete Anzeigeelemente 28g, 52g auf. Die weiteren Anzeigeelemente 52g sind parallel geschaltet zu den restlichen drei Anzeigeelementen 28g angeordnet. Insbesondere kann es sein, dass ab einer bestimmten Anzahl von seriell geschalteten Anzeigeelementen 28g, eine Packspannung des Akkupacks 12g nicht mehr ausreicht, um die Anzeigeelemente 28g, 52g mit einer ausreichend hohen Spannung zu versorgen. Die Ladezustandsanzeigeeinheit 18g weist für die zwei weiteren Anzeigeelemente 52g jeweils ein weiteres Transistorelement 54g auf, welche dazu eingerichtet sind, dass weitere Anzeigeelement 52g in einer Leitermasche des jeweiligen Transistorelements 54g in Abhängigkeit von einem elektrischen und/oder elektronischen Signal einer Kontrolleinheit 16g des Akkupacks 12g kurzzuschließen.

## Patentansprüche

1. Anzeigevorrichtung für einen Akkupack, insbesondere einen Akkupack eines Elektrowerkzeugs, zum Anzeigen eines Ladezustands des Akkupacks, mit zumindest einer Ladezustandsanzeigeeinheit (18a; 18b; 18c; 18d; 18e; 18f; 18g), die zumindest ein Anzeigeelement (28a; 28b; 28c; 28d; 28e; 28f, 52f; 28g, 52g) zum Anzeigen des Ladezustands des Akkupacks (12a; 12b; 12c; 12d; 12e; 12f; 12g) aufweist, und mit zumindest einer Steuerleitung (20a; 20b; 20c; 20d; 20e; 20f; 20g) zu einer Übertragung von zumindest einem, insbesondere von einem Ladezustand des Akkupacks (12a; 12b; 12c; 12d; 12e; 12f; 12g) abhängigen, elektrischen und/oder elektronischen Signal von einer zur Ladezustandsanzeigeeinheit (18a; 18b; 18c; 18d; 18e; 18f; 18g), insbesondere baulich getrennten, separaten Kontrolleinheit (16a; 16b; 16c; 16d; 16e; 16f; 16g) des Akkupacks (12a; 12b; 12c; 12d; 12e; 12f; 12g), insbesondere von einer Hauptsteuerelektronik des Akkupacks (12a; 12b; 12c; 12d; 12e; 12f; 12g), zur Ladezustandsanzeigeeinheit (18a; 18b; 18c; 18d; 18e; 18f; 18g), wobei die Ladezustandsanzeigeeinheit (18a; 18b; 18c; 18d; 18e; 18f; 18g) dazu eingerichtet ist, zumindest das eine Anzeigeelement (28a; 28b; 28c; 28d; 28e; 28f, 52f; 28g, 52g) in Abhängigkeit von dem über die Steuerleitung (20a; 20b; 20c; 20d; 20e; 20f; 20g) übertragenen elektrischen und/oder elektronischen Signal kurzzuschließen, **gekennzeichnet durch** zumindest zwei mit der Steuerleitung (20a; 20b; 20c; 20d; 20e; 20f; 20g) elektrisch leitend verbundene Steuerwiderstände (32a), die jeweils, insbesondere direkt, mit zumindest einem Signalausgang (34a) der Kontrolleinheit (16a; 16b; 16c; 16d; 16e; 16f; 16g) des Akkupacks (12a; 12b; 12c; 12d; 12e; 12f; 12g) verbunden sind.

2. Anzeigevorrichtung nach Anspruch 1, **dadurch gekennzeichnet, dass** die Ladezustandsanzeigeeinheit (18a; 18b; 18c; 18d; 18e; 18f; 18g) zumindest ein Transistorelement (30a; 54g; 54f) aufweist, welches parallelgeschaltet zum Anzeigeelement (28a; 28b; 28c; 28d; 28e; 28f, 52f; 28g, 52g) angeordnet ist und dazu eingerichtet ist, in Abhängigkeit von einem über die Steuerleitung (20a; 20b; 20c; 20d; 20e; 20f; 20g) übertragenen elektrischen und/oder elektronischen Signal zumindest das Anzeigeelement (28a; 28b; 28c; 28d; 28e; 28f, 52f; 28g, 52g) kurzzuschließen.

3. Anzeigevorrichtung nach Anspruch 1 oder 2, **gekennzeichnet durch** zumindest eine Bedieneinheit (36b; 36c; 36d; 36e; 36f), die zumindest ein Bedienelement (38b) aufweist, welches dazu eingerichtet ist, die Ladezustandsanzeigeeinheit (18a; 18b; 18c; 18d; 18e; 18f; 18g) über die Kontrolleinheit (16a; 16b; 16c; 16d; 16e; 16f; 16g) des Akkupacks (12a; 12b; 12c; 12d; 12e; 12f; 12g), insbesondere die Hauptsteuerelektronik des Akkupacks (12a; 12b; 12c; 12d; 12e; 12f; 12g), zu aktivieren.

4. Anzeigevorrichtung nach einem der vorhergehenden Ansprüche, **dadurch gekennzeichnet, dass** die Ladezustandsanzeigeeinheit (18a; 18b; 18c; 18d; 18e; 18f; 18g) zumindest eine Spannungsstabilisierungseinheit (40c; 40d) umfasst, welche zumindest eine Zehnerdiode aufweist.

5. Anzeigevorrichtung nach einem der vorhergehenden Ansprüche, **dadurch gekennzeichnet, dass** die Ladezustandsanzeigeeinheit (18a; 18b; 18c; 18d; 18e; 18f; 18g) zumindest einen Umverteilungswiderstand (48e) aufweist, welcher dazu eingerichtet ist, den Leistungsabfall innerhalb der Ladezustandsanzeigeeinheit (18a; 18b; 18c; 18d; 18e; 18f; 18g) zu verteilen, wobei der Umverteilungswiderstand (48e) zwischen dem Anzeigeelement (28a; 28b; 28c; 28d; 28e; 28f, 52f; 28g, 52g) und einem Transistorelement (30a; 54g; 54f) der Ladezustandsanzeigeeinheit (18a; 18b; 18c; 18d; 18e; 18f; 18g) angeordnet ist.

6. Akkupack, insbesondere Akkupack eines Elektrowerkzeugs, mit zumindest einer Kontrolleinheit (16a; 16b; 16c; 16d; 16e; 16f; 16g), insbesondere einer Hauptsteuerelektronik, und mit zumindest einer Anzeigevorrichtung (14a; 14b; 14c; 14d; 14e; 14f; 14g) nach einem der vorhergehenden Ansprüche.

7. Verfahren zum Anzeigen eines Ladezustands eines Akkupacks, insbesondere eines Akkupacks eines Elektrowerkzeugs, mittels zumindest einer Anzeigevorrichtung nach einem der Ansprüche 1 bis 5, wobei in zumindest einem Verfahrensschritt (42a) zumindest ein Anzeigeelement (28a; 28b; 28c; 28d; 28e; 28f, 52f; 28g, 52g) einer Ladezustandsanzeigeeinheit (18a; 18b; 18c; 18d; 18e; 18f; 18g) in Abhängigkeit von einem, insbesondere von einem Ladezustand des Akkupacks (12a; 12b; 12c; 12d; 12e; 12f; 12g) abhängigen, über eine Steuerleitung (20a; 20b; 20c; 20d; 20e; 20f; 20g) übertragenen elektrischen und/oder elektronischen Signals einer zur Ladezustandsanzeigeeinheit (18a; 18b; 18c; 18d; 18e; 18f; 18g), insbesondere baulich getrennten, separaten Kontrolleinheit (16a; 16b; 16c; 16d; 16e; 16f; 16g) des Akkupacks (12a; 12b; 12c; 12d; 12e; 12f; 12g), insbesondere einer Hauptsteuerelektronik des Akkupacks (12a; 12b; 12c; 12d; 12e; 12f; 12g), kurzgeschlossen wird, **dadurch gekennzeichnet, dass** in zumindest einem Verfahrensschritt (44a) aus zumindest zwei Spannungspegeln der Kontrolleinheit (16a; 16b; 16c; 16d; 16e; 16f; 16g) des Akkupacks (12a; 12b; 12c; 12d; 12e; 12f; 12g), zumindest zwei Steuerwiderständen (32a) zumindest mehr als ein unterschiedliches elektrisches und/oder elektronisches Signal zur Steuerung der Ladezustandsanzeigeeinheit (18a; 18b; 18c; 18d; 18e; 18f; 18g) generiert wird.

8. Verfahren nach Anspruch 7, **dadurch gekennzeichnet, dass** ein Kurzschließen des Anzeigeelements (28a; 28b; 28c; 28d; 28e; 28f, 52f; 28g, 52g) über zumindest ein Transistorelement (30a; 54g; 54f) der Ladezustandsanzeigeeinheit (18a; 18b; 18c; 18d; 18e; 18f; 18g) erfolgt, welcher in Abhängigkeit von dem elektrischen und/oder elektronischen Signal der Kontrolleinheit (16a; 16b; 16c; 16d; 16e; 16f; 16g) des Akkupacks (12a; 12b; 12c; 12d; 12e; 12f; 12g) geschaltet wird.

9. Verfahren nach Anspruch 7, **dadurch gekennzeichnet, dass** die Ladezustandsanzeigeeinheit (18a; 18b; 18c; 18d; 18e; 18f; 18g) mittels zumindest einer Packspannung des Akkupacks (12a; 12b; 12c; 12d; 12e; 12f; 12g) über zumindest eine Versorgungsleitung (22a; 22b; 22c; 22d; 22e; 22f; 22g) mit Strom versorgt wird.

## Claims

1. Display device for a rechargeable battery pack, in particular a rechargeable battery pack for an electric tool, for displaying a state of charge of the rechargeable battery pack, comprising at least one state of charge display unit (18a; 18b; 18c; 18d; 18e; 18f; 18g) that has at least one display element (28a; 28b; 28c; 28d; 28e; 28f, 52f; 28g, 52g) for displaying the state of charge of the rechargeable battery pack (12a; 12b; 12c; 12d; 12e; 12f; 12g), and comprising at least one control line (20a; 20b; 20c; 20d; 20e; 20f; 20g) for transmitting at least one electrical and/or electronic signal, which is in particular dependent on a state of charge of the rechargeable battery pack (12a; 12b; 12c; 12d; 12e; 12f; 12g), from a control unit (16a; 16b; 16c; 16d; 16e; 16f; 16g), which is separate from, in particular structurally separated from, the state of charge display unit (18a; 18b; 18c; 18d; 18e; 18f; 18g), of the rechargeable battery pack (12a; 12b; 12c; 12d; 12e; 12f; 12g), in particular from main control electronics of the rechargeable battery pack (12a; 12b; 12c; 12d; 12e; 12f; 12g), to the state of charge display unit (18a; 18b; 18c; 18d; 18e; 18f; 18g), wherein the state of charge display unit (18a; 18b; 18c; 18d; 18e; 18f; 18g) is configured to short-circuit at least the one display element (28a; 28b; 28c; 28d; 28e; 28f, 52f; 28g, 52g) depending on the electrical and/or electronic signal transmitted via the control line (20a; 20b; 20c; 20d; 20e; 20f; 20g), **characterized by** at least two control resistors (32a) that are electrically conductively connected to the control line (20a; 20b; 20c; 20d; 20e; 20f; 20g) and are each connected, in particular directly, to at least one signal output (34a) of the control unit (16a; 16b; 16c; 16d; 16e; 16f; 16g) of the rechargeable battery pack (12a; 12b; 12c; 12d; 12e; 12f; 12g).

2. Display device according to Claim 1, **characterized in that** the state of charge display unit (18a; 18b; 18c; 18d; 18e; 18f; 18g) has at least one transistor element (30a; 54g; 54f) that is arranged so as to be connected in parallel with the display element (28a; 28b; 28c; 28d; 28e; 28f, 52f; 28g, 52g) and is configured to short-circuit at least the display element (28a; 28b; 28c; 28d; 28e; 28f, 52f; 28g, 52g) depending on an electrical and/or electronic signal transmitted via the control line (20a; 20b; 20c; 20d; 20e; 20f; 20g).

3. Display device according to Claim 1 or 2, **characterized by** at least one operating unit (36b; 36c; 36d; 36e; 36f) that has at least one operating element (38b) that is configured to activate the state of charge display unit (18a; 18b; 18c; 18d; 18e; 18f; 18g) via the control unit (16a; 16b; 16c; 16d; 16e; 16f; 16g) of the rechargeable battery pack (12a; 12b; 12c; 12d; 12e; 12f; 12g), in particular the main control electronics of the rechargeable battery pack (12a; 12b; 12c; 12d; 12e; 12f; 12g) .

4. Display device according to one of the preceding claims, **characterized in that** the state of charge display unit (18a; 18b; 18c; 18d; 18e; 18f; 18g) comprises at least one voltage stabilization unit (40c; 40d) that has at least one Zener diode.

5. Display device according to one of the preceding claims, **characterized in that** the state of charge display unit (18a; 18b; 18c; 18d; 18e; 18f; 18g) has at least one redistribution resistor (48e) that is configured to distribute the power drop within the state of charge display unit (18a; 18b; 18c; 18d; 18e; 18f; 18g), wherein the redistribution resistor (48e) is arranged between the display element (28a; 28b; 28c; 28d; 28e; 28f, 52f; 28g, 52g) and a transistor element (30a; 54g; 54f) of the state of charge display unit (18a; 18b; 18c; 18d; 18e; 18f; 18g).

6. Rechargeable battery pack, in particular rechargeable battery pack for an electric tool, comprising at least one control unit (16a; 16b; 16c; 16d; 16e; 16f; 16g), in particular main control electronics, and comprising a display device (14a; 14b; 14c; 14d; 14e; 14f; 14g) according to one of the preceding claims.

7. Method for displaying a state of charge of a rechargeable battery pack, in particular a rechargeable battery pack for an electric tool, by means of at least one display device according to one of Claims 1 to 5, wherein, in at least one method step (42a), at least one display element (28a; 28b; 28c; 28d; 28e; 28f, 52f; 28g, 52g) of a state of charge display unit (18a; 18b; 18c; 18d; 18e; 18f; 18g) is short-circuited depending on an electrical and/or electronic signal, which is in particular dependent on a state of charge of the rechargeable battery pack (12a; 12b; 12c; 12d; 12e; 12f; 12g) and transmitted via a control line (20a; 20b; 20c; 20d; 20e; 20f; 20g), of a control unit (16a; 16b; 16c; 16d; 16e; 16f; 16g), which is separate from, in particular structurally separated from, the state of charge display unit (18a; 18b; 18c; 18d; 18e; 18f; 18g), of the rechargeable battery pack (12a; 12b; 12c; 12d; 12e; 12f; 12g), in particular of main control electronics of the rechargeable battery pack (12a; 12b; 12c; 12d; 12e; 12f; 12g), **characterized in that,** in at least one method step (44a), at least more than one different electrical and/or electronic signal is generated from at least two voltage levels of the control unit (16a; 16b; 16c; 16d; 16e; 16f; 16g) of the rechargeable battery pack (12a; 12b; 12c; 12d; 12e; 12f; 12g) by means of at least two control resistors (32a) in order to control the state of charge display unit (18a; 18b; 18c; 18d; 18e; 18f; 18g) .

8. Method according to Claim 7, **characterized in that** the display element (28a; 28b; 28c; 28d; 28e; 28f, 52f; 28g, 52g) is short-circuited by way of at least one transistor element (30a; 54g; 54f) of the state of charge display unit (18a; 18b; 18c; 18d; 18e; 18f; 18g), which transistor element is switched depending on the electrical and/or electronic signal of the control unit (16a; 16b; 16c; 16d; 16e; 16f; 16g) of the rechargeable battery pack (12a; 12b; 12c; 12d; 12e; 12f; 12g).

9. Method according to Claim 7, **characterized in that** the state of charge display unit (18a; 18b; 18c; 18d; 18e; 18f; 18g) is supplied with power by means of at least one pack voltage of the rechargeable battery pack (12a; 12b; 12c; 12d; 12e; 12f; 12g) via at least one supply line (22a; 22b; 22c; 22d; 22e; 22f; 22g).

## Revendications

1. Dispositif d'affichage pour un bloc-batterie, en particulier un bloc-batterie d'un outil électrique, pour afficher un état de charge du bloc-batterie, comprenant au moins une unité d'affichage d'état de charge **(18a** ; **18b** ; **18c** ; **18d** ; **18e** ; **18f** ; **18g**) qui présente au moins un élément d'affichage (**28a** ; **28b** ; **28c** ; **28d** ; **28e** ; **28f, 52f** ; **28g, 52g)** pour afficher l'état de charge du bloc-batterie **(12a** ; **12b** ; **12c** ; **12d** ; **12e** ; **12f** ; **12g)** , et comprenant au moins une ligne de commande (**20a** ; **20b** ; **20c** ; **20d** ; **20e** ; **20f** ; 20g) pour transmettre au moins un signal électrique et/ou électronique, en particulier dépendant d'un état de charge du bloc-batterie **(12a** ; **12b** ; **12c** ; **12d** ; **12e** ; **12f** ; **12g**), d'une unité de contrôle **(16a** ; **16b** ; **16c** ; **16d** ; **16e** ; **16f** ; **16g)** du bloc-batterie **(12a** ; **12b** ; **12c** ; **12d** ; **12e** ; **12f** ; **12g**), séparée de l'unité d'affichage d'état de charge (**18a** ; **18b** ; **18c** ; **18d** ; **18e** ; **18f** ; **18g)**, en particulier séparée par construction, en particulier d'une électronique de commande principale du bloc-batterie (**12a** ; **12b** ; **12c** ; **12d** ; **12e** ; **12f** ; **12g)**, à l'unité d'affichage d'état de charge (**18a** ; **18b** ; **18c** ; **18d** ; **18e** ; **18f** ; **18g**), dans lequel l'unité d'affichage d'état de charge (**18a** ; **18b ; 18c ; 18d ; 18e** ; **18f ; 18g**) est conçue pour mettre en court-circuit au moins ledit un élément d'affichage (**28a** ; **28b** ; **28c** ; **28d** ; **28e** ; **28f,** 52f ; 28g, 52g) en fonction du signal électrique et/ou électronique transmis sur la ligne de commande (**20a** ; **20b** ; **20c** ; **20d** ; **20e** ; **20f** ; **20g)**,
**caractérisé par** au moins deux résistances de commande (32a) reliées de manière électriquement conductrice à la ligne de commande (20a ; 20b ; 20c ; 20d ; 20e ; 20f ; 20g) qui sont reliées respectivement, en particulier directement, à au moins une sortie de signal (34a) de l'unité de contrôle (16a ; 16b ; 16c ; 16d ; 16e ; 16f ; 16g) du bloc-batterie (12a ; 12b ; 12c ; 12d ; 12e ; 12f ; 12g).

2. Dispositif d'affichage selon la revendication 1, **caractérisé en ce que** l'unité d'affichage d'état de charge (18a ; 18b ; 18c ; 18d ; 18e ; 18f ; 18g) présente au moins un élément de transistor (30a ; 54g ; 54f) qui est disposé en étant monté en parallèle à l'élément d'affichage (28a ; 28b ; 28c ; 28d ; 28e ; 28f, 52f ; 28g, 52g) et est conçu pour mettre en court-circuit au moins l'élément d'affichage (28a ; 28b ; 28c ; 28d ; 28e ; 28f, 52f ; 28g, 52g) en fonction d'un signal électrique et/ou électronique transmis sur la ligne de commande (20a ; 20b ; 20c ; 20d ; 20e ; 20f ; 20g) .

3. Dispositif d'affichage selon la revendication 1 ou 2, **caractérisé par** au moins une unité d'actionnement (36b ; 36c ; 36d ; 36e ; 36f) qui présente au moins un élément d'actionnement (38b) qui est conçu pour activer l'unité d'affichage d'état de charge (18a ; 18b ; 18c ; 18d ; 18e ; 18f ; 18g) par l'intermédiaire de l'unité de contrôle (16a ; 16b ; 16c ; 16d ; 16e ; 16f ; 16g) du bloc-batterie (12a ; 12b ; 12c ; 12d ; 12e ; 12f ; 12g), en particulier l'électronique de commande principale du bloc-batterie (12a ; 12b ; 12c ; 12d ; 12e ; 12f ; 12g).

4. Dispositif d'affichage selon l'une quelconque des revendications précédentes, **caractérisé en ce que** l'unité d'affichage d'état de charge (18a ; 18b ; 18c ; 18d ; 18e ; 18f ; 18g) comprend au moins une unité de stabilisation de tension (40c ; 40d) qui présente au moins une diode Zener.

5. Dispositif d'affichage selon l'une quelconque des revendications précédentes, **caractérisé en ce que** l'unité d'affichage d'état de charge (18a ; 18b ; 18c ; 18d ; 18e ; 18f ; 18g) présente au moins une résistance de redistribution (48e) qui est conçue pour répartir la perte de puissance à l'intérieur de l'unité d'affichage d'état de charge (18a ; 18b ; 18c ; 18d ; 18e ; 18f ; 18g), dans lequel la résistance de redistribution (48e) est disposée entre l'élément d'affichage (28a ; 28b ; 28c ; 28d ; 28e ; 28f, 52f ; 28g, 52g) et un élément de transistor (30a ; 54g ; 54f) de l'unité d'affichage d'état de charge (18a ; 18b ; 18c ; 18d ; 18e ; 18f ; 18g) .

6. Bloc-batterie, en particulier bloc-batterie d'un outil électrique, comprenant au moins une unité de contrôle (16a ; 16b ; 16c ; 16d ; 16e ; 16f ; 16g), en particulier une électronique de commande principale, et au moins un dispositif d'affichage (14a ; 14b ; 14c ; 14d ; 14e ; 14f ; 14g) selon l'une quelconque des revendications précédentes.

7. Procédé permettant d'afficher un état de charge d'un bloc-batterie, en particulier d'un bloc-batterie d'un outil électrique, au moyen d'au moins un dispositif d'affichage selon l'une quelconque des revendications 1 à 5, dans lequel dans au moins une étape de procédé (42a), au moins un élément d'affichage (28a ; 28b ; 28c ; 28d ; 28e ; 28f, 52f ; 28g, 52g) d'une unité d'affichage d'état de charge (18a ; 18b ; 18c ; 18d ; 18e ; 18f ; 18g) est mis en court-circuit en fonction d'un signal électrique et/ou électronique dépendant en particulier d'un état de charge du bloc-batterie (12a ; 12b ; 12c ; 12d ; 12e ; 12f ; 12g) et transmis sur une ligne de commande (20a ; 20b ; 20c ; 20e ; 20f ; 20g) d'une unité de contrôle (16a ; 16b ; 16c ; 16d ; 16e ; 16f ; 16g) du bloc-batterie (12a ; 12b ; 12c ; 12d ; 12e ; 12f ; 12g), séparée de l'unité d'affichage d'état de charge (18a ; 18b ; 18c ; 18d ; 18e ; 18f ; 18g), en particulier séparée par construction, en particulier d'une électronique de commande principale du bloc-batterie (12a ; 12b ; 12c ; 12d ; 12e ; 12f ; 12g),
**caractérisé en ce que** dans au moins une étape de procédé (44a) au moins plus d'un signal électrique et/ou électronique différent est généré pour commander l'unité d'affichage d'état de charge (18a ; 18b ; 18c ; 18d ; 18e ; 18f ; 18g) à partir d'au moins deux niveaux de tension de l'unité de contrôle (16a ; 16b ; 16c ; 16d ; 16e ; 16f ; 16g) du bloc-batterie (12a ; 12b ; 12c ; 12d ; 12e ; 12f ; 12g), et d'au moins deux résistances de commande (32a).

8. Procédé selon la revendication 7, **caractérisé en ce qu'**une mise en court-circuit de l'élément d'affichage (28a ; 28b ; 28c ; 28d ; 28e ; 28f, 52f ; 28g, 52g) est effectuée par l'intermédiaire d'au moins un élément de transistor (30a ; 54g ; 54f) de l'unité d'affichage d'état de charge (18a ; 18b ; 18c ; 18d ; 18e ; 18f ; 18g) qui est commuté en fonction du signal électrique et/ou électronique de l'unité de contrôle (16a ; 16b ; 16c ; 16d ; 16e ; 16f ; 16g) du bloc-batterie (12a ; 12b ; 12c ; 12d ; 12e ; 12f ; 12g).

9. Procédé selon la revendication 7, **caractérisé en ce que** l'unité d'affichage d'état de charge (18a ; 18b ; 18c ; 18d ; 18e ; 18f ; 18g) est alimentée en courant au moyen d'au moins une tension de bloc du bloc-batterie (12a ; 12b ; 12c ; 12d ; 12e ; 12f ; 12g) par au moins une ligne d'alimentation (22a ; 22b ; 22c ; 22d ; 22e ; 22f ; 22g).
